# FASCICULE DE BREVET EUROPEEN

(11) **EP 3 233 499 B1**
(45) Date de publication et mention de la délivrance du brevet: **22.05.2019**
(21) Numéro de dépôt: 15837086.6
(22) Date de dépôt: 17.12.2015
(51) Int. Cl.: B41J 2/14

(54) **PROCÉDÉ D'IMPRESSION PAR LASER ET DISPOSITIF POUR SA MISE EN OEUVRE**
LASERDRUCKVERFAHREN UND VORRICHTUNG ZUR UMSETZUNG DIESES VERFAHRENS
LASER PRINTING METHOD, AND DEVICE FOR IMPLEMENTING SAID METHOD

(30) Priorité: 17.12.2014 FR 1462568
(43) Date de publication de la demande: 25.10.2017
(73) Titulaire: Université de Bordeaux, 33000 Bordeaux (FR); Institut National de la Santé et de la Recherche Médicale (INSERM), 75013 Paris (FR)
(72) Inventeur: GUILLEMOT, Fabien, 33210 Preignac (FR)
(74) Mandataire: IP Trust
(86) Numéro de dépôt international: PCT/FR2015/053569
(87) Numéro de publication internationale: WO 2016/097619

(56) Documents cités:
- WO-A1-2011/107599
- WO-A2-03/056320
- DE-A1- 3 702 643
- JP-A- S62 191 157
- US-A- 5 521 140
- US-A1- 2008 117 255

## Description

La présente invention se rapporte à un procédé d'impression par laser ainsi qu'à un dispositif pour sa mise en oeuvre.

L'impression d'encre est utilisée dans de nombreux domaines pour reproduire des motifs complexes. Ainsi, l'impression d'éléments peut notamment être mise en oeuvre dans des domaines aussi variés que la biologie, l'électronique, les matériaux ou l'horlogerie. Les problématiques rencontrées dans ces différents domaines sont similaires et ont trait notamment aux besoins de réaliser des combinaisons d'éléments à de très petites échelles. Une reproduction de motifs qui consiste à déposer de la matière à des endroits spécifiques peut être réalisée par voie chimique ou physique via l'utilisation de masques ou via le recours à une étape d'ablation sélective.

Pour remédier aux inconvénients de ces méthodes (risque de contamination, complexité de mise en oeuvre, difficulté de combiner le dépôt de plusieurs éléments), des procédés d'impression d'encre ont été développés. Ils présentent l'avantage de pouvoir générer très librement des motifs d'éléments grâce aux outils de conception assistée par ordinateur auxquels ils sont associés.

Dans le domaine de la biologie, selon les ouvrages, ces procédés d'impression sont appelés bio-impression, micro-impression d'éléments biologiques ou bioprinting en anglais.

Selon ces procédés, le tissu biologique est obtenu en imprimant des gouttelettes d'encres biologiques. Pour obtenir un volume, les gouttelettes sont agencées par couches qui sont superposées les unes sur les autres.

Selon une première variante, l'encre est stockée dans un réservoir et passe à travers des buses ou des capillaires pour former des gouttelettes qui sont transférées sur un support. Cette première variante d'impression dite à buse regroupe la bioextrusion, l'impression jet d'encre ou l'impression par microvannes.

La bioextrusion permet d'obtenir une densité cellulaire importante de l'ordre de 100 millions de cellules par millilitre et une résolution de l'ordre du millimètre.

L'impression par microvannes permet d'obtenir une densité cellulaire moindre de l'ordre de quelques millions de cellules par millilitre et une résolution meilleure de l'ordre de 100 µm. L'impression jet d'encre permet d'obtenir une densité cellulaire identique à l'impression par microvannes, inférieure à 10 millions de cellules par millilitre et une résolution meilleure de l'ordre de 10 µm.

Dans le cas de la bioextrusion, les cellules sont déposées à partir d'une première buse et un hydrogel est simultanément déposé à partir d'une seconde buse. En variante, les cellules et l'hydrogel sont mixés dans un réservoir avant extrusion. Dans les deux autres cas, l'encre est un milieu aqueux contenant les cellules. Selon les variantes, la bioextrusion permet de déposer l'encre de manière continue sous la forme de filaments ou de manière discontinue sous forme de gouttelettes.

Selon ces modes d'impression à buse, la résolution d'impression étant liée notamment à la section des buses, seules des encres biologiques avec des caractéristiques rhéologiques données peuvent être utilisées pour des résolutions élevées. Ainsi, des encres biologiques à forte densité cellulaire peuvent être difficilement imprimées avec une résolution élevée car cette technique d'impression induit au moment du passage à travers la buse des contraintes de cisaillement importantes susceptibles d'endommager les cellules. De plus, avec ce type d'encre, les risques d'obturation des buses par les cellules sont importants du fait notamment de la sédimentation des cellules à l'intérieur des réservoirs.

Pour pouvoir utiliser une large gamme d'encres biologiques et atteindre un niveau élevé de résolution, un procédé d'impression d'éléments biologiques par laser a été développé. Ce procédé d'impression appelé bio-impression par laser, est également connu sous le nom de « Laser-Assisted Bioprinting » (LAB) en anglais. L'invention se rapporte plus précisément à ce type de procédés d'impression. A titre de comparaison, la bio-impression par laser permet d'imprimer des encres présentant une forte densité cellulaire de l'ordre de 100 millions de cellules par millilitre avec une résolution de 10 µm.

De la même façon, l'impression par laser a été également développée dans d'autres domaines pour pouvoir améliorer la résolution et élargir la gamme d'encres utilisables.

Par rapport aux techniques d'impression à buse, l'impression laser procure une plus grande souplesse d'utilisation (possibilité d'imprimer sur des surfaces molles, non planes,...), réduit les contraintes de cisaillement, limite les risques de sédimentation. Selon un autre avantage, il est possible d'imprimer à partir d'un faible volume d'encre de l'ordre de quelques microlitres ce qui est intéressant pour les dépôts de matières chères. Enfin, il est possible d'utiliser le système d'impression pour visualiser et sélectionner la zone de dépôt comme décrit dans le document WO2011/107599.

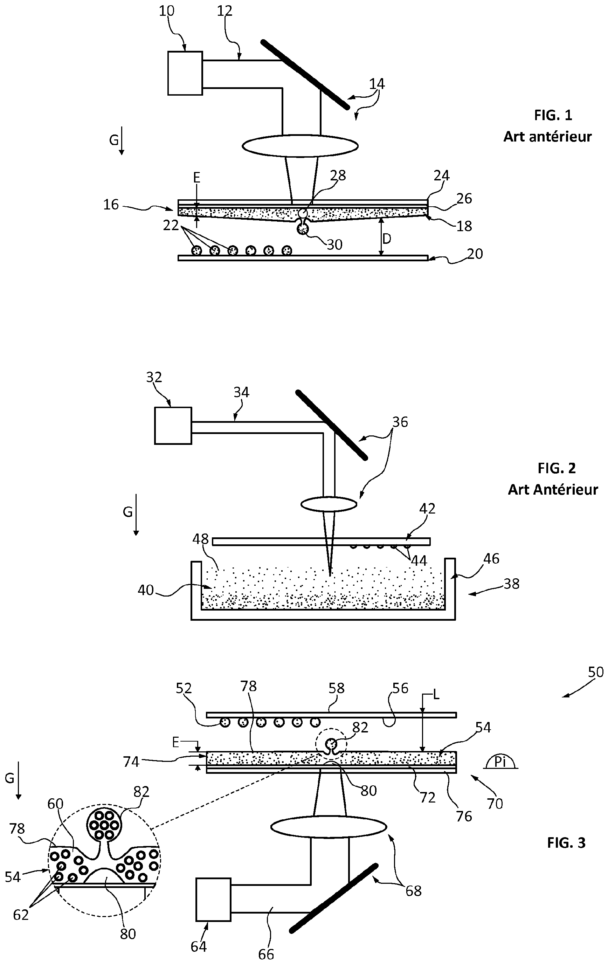

Comme illustré sur la figure 1, un dispositif d'impression d'éléments biologiques par laser qui repose sur la technique dénommée « Laser-Induced Forward Transfer » (LIFT) en anglais, comprend une source laser pulsée 10 émettant un faisceau laser 12, un système 14 pour focaliser et orienter le faisceau laser 12, un support donneur 16 qui comporte au moins une encre biologique 18 et un substrat receveur 20 positionné de manière à recevoir des gouttelettes 22 émises depuis le support donneur 16.

Selon cette technique d'impression, le faisceau laser est pulsé et à chaque impulsion une gouttelettes est générée.

L'encre biologique 18 comprend une matrice, par exemple un milieu aqueux, dans laquelle sont présents des éléments, par exemple des cellules, à déposer sur le substrat receveur 20. Le support donneur 16 comprend une lame 24 transparente à la longueur d'onde du faisceau laser 12 qui est revêtue d'une couche absorbante 26 sur laquelle est apposée l'encre biologique 18 sous la forme d'un film.

La couche absorbante 26 permet de convertir l'énergie lumineuse en énergie cinétique. Ainsi, le faisceau laser 12 produit un échauffement ponctuel au niveau de la couche absorbante 26 qui génère par vaporisation une bulle de gaz 28 qui par expansion provoque l'éjection d'une gouttelette 30 d'encre biologique.

Selon un agencement connu, le faisceau laser 12 impacte le support donneur 16 en étant orienté selon une direction approximativement verticale et selon un sens de haut en bas, soit dans le même sens que la force gravitationnelle G. Ainsi, l'encre biologique 18 est placée sous la lame 24 de manière à être orientée vers le bas en direction du substrat receveur 20 qui est placé sous le support donneur 16.

Compte tenu de cet agencement, l'encre biologique 18 est sous la forme d'un film avec une épaisseur E inférieure à un seuil donné pour pouvoir être maintenue sur la lame. Ce seuil varie notamment en fonction de la tension de surface, de la viscosité et de la densité de l'encre biologique.

La formation des gouttelettes 30 à partir du film d'encre dépend de nombreux paramètres qui sont relatifs notamment au faisceau laser 12 (longueur d'onde, énergie, durée d'impulsion,...), à la nature de l'encre biologique 18 (tension de surface, viscosité,...), aux conditions extérieures (température, hygrométrie,...).

La formation des gouttelettes 30 dépend également de l'épaisseur du film E de l'encre biologique. Les gouttelettes ne vont pas se former si l'épaisseur E du film d'encre biologique n'est pas comprise dans une plage d'épaisseurs délimitée par une borne inférieure et une borne supérieure. Si l'épaisseur E a une valeur supérieure à la borne supérieure, aucune gouttelette ne va se former car l'expansion de la bulle de gaz 28 est trop faible pour atteindre la surface libre du film. Si l'épaisseur E a une valeur inférieure à la borne inférieure, la bulle de gaz 28 va éclater au niveau de la surface libre provoquant la projection incontrôlée d'une pluralité de microgouttelettes vers le substrat receveur.

Par conséquent, l'épaisseur du film E doit être sensiblement constante sur toute la surface du support donneur 16 pour obtenir une reproductibilité de la formation des gouttelettes quelle que soit la zone du support donneur 16 impactée par le faisceau laser 12. Or, comme illustré sur la figure 1, cette épaisseur E n'est pas constante.

Ce problème de reproductibilité n'est pas limité au cas des encres biologiques. Il est présent quel que soit le domaine d'utilisation lors de l'impression par laser d'un film d'encre.

Pour remédier à cette problématique, une publication intitulée « Microdroplet deposition through a film-free laser forward technique » parue le 1 Octobre 2011 sur le site www.elsevier.com propose un dispositif tel que décrit sur la figure 2. Comme précédemment, ce dispositif comprend une source laser 32 émettant un faisceau laser 34, un système 36 pour focaliser et orienter le faisceau laser 34, un support donneur 38 qui contient au moins une encre biologique 40 ainsi qu'un substrat receveur 42 positionné de manière à recevoir des gouttelettes 44 émises depuis le support donneur 38.

Selon cette publication, le support donneur 38 comprend un réservoir 46 sans paroi supérieure de sorte que la surface libre 48 de l'encre biologique 40 contenue dans le réservoir fait face au substrat receveur 42. Pour obtenir une surface libre 48 régulière et sensiblement plane, l'encre biologique ne se présente pas sous la forme d'un film mince mais d'un volume ayant une profondeur de l'ordre de 3 mm. De la sorte, le fond du réservoir n'a pas d'influence sur la forme de la surface libre 48 de l'encre biologique et les parois latérales du réservoir ont un effet limité à la périphérie de la surface libre 48 en raison de la tension de surface.

Compte tenu de la profondeur du volume d'encre biologique, la surface libre 48 est nécessairement orientée vers le haut pour rester dans le réservoir et le substrat receveur 42 est positionné au-dessus de l'encre biologique 40.

Selon ce document, pour obtenir l'éjection d'une gouttelette, le faisceau laser 34 est focalisé juste en-dessous de la surface libre 48 a une profondeur de l'ordre de 40 à 80 µm. Ainsi, les gouttelettes émises à partir de la surface libre 48 sont projetées vers le substrat receveur 42 selon un sens de déplacement contraire au sens de la force gravitationnelle G.

Même si la solution proposée par cette publication permet d'obtenir une surface libre 48 pour l'encre plane, elle n'est pas forcément adaptée aux encres qui sont sous forme de suspensions, comme par exemple les encres biologiques. En effet, comme indiqué précédemment, ces encres biologiques contiennent des éléments à imprimer, comme par exemple des cellules, noyés dans une matrice, qui ont tendance par sédimentation à descendre en fond de réservoir. La concentration en éléments à imprimer étant faible à proximité de la surface libre, les gouttelettes imprimées ont de fait de faibles concentrations en cellules ce qui est généralement préjudiciable pour le tissu biologique imprimé. De plus, selon cette méthode, il est très difficile de contrôler le nombres de cellules et la concentration des cellules déposées.

Ce problème de sédimentation n'est pas limité aux encres biologiques. Ainsi, on le retrouve lors de l'impression laser des encres sous forme de suspensions, comme par exemple des suspensions de particules ou de nanoparticules dans une matrice liquide, quel que soit le domaine d'application de ces encres.

Selon un autre inconvénient du procédé de la publication, l'encre doit pouvoir absorber le faisceau laser ce qui peut limiter la gamme d'encres susceptibles d'être imprimées selon cette technique.

On connaît aussi la demande de brevet US2008/117255 qui décrit un dispositif d'éjection de micro-fluide, par exemple une tête d'impression à jet d'encre utilisant un laser pour éjecter du fluide. Il comprend une plaque de passage définissant une chambre de fluide remplie de fluide et un canal de fluide pour fournir à la chambre de fluide un fluide, une plaque supérieure prévue sur la plaque de passage, un trou d'éjection de fluide formé à travers la plaque supérieure à un position correspondant à la chambre de fluide, une lentille de condenseur prévue sur une surface inférieure de la plaque de passage en une position correspondant à la chambre de fluide et un irradiateur à faisceau laser capable d'irradier un faisceau laser à travers la lentille de condensateur et dans un fluide contenu dans la chambre de fluide , dans lequel le fluide est nucléé par le faisceau laser de telle sorte qu'une bulle de vapeur forme et déplace une partie du fluide, éjectant ainsi une gouttelette de fluide dans le trou d'éjection de fluide.

Un brevet similaire, US5521140 décrit un système comprenant une couche de matériau d'enregistrement face à un corps d'enregistrement avec un espace incorporé entre eux, de sorte que ledit matériau d'enregistrement est vaporisé et transféré audit corps d'enregistrement à travers ledit espace, à condition que des pores soient prévus sur une partie de vaporisation du matériau d'enregistrement de telle manière que les pores soient présents dans la couche du matériau d'enregistrement. La structure de l'unité d'enregistrement de la présente invention assure un enregistrement d'excellente qualité, est compacte et légère, donne un rendement thermique élevé et ne produit pas de feuilles d'encre usées et d'autres déchets.

On connaît encore la demande de brevet internationale WO2003/056320 décrivant un procédé et un appareil permettant de microusiner avec précision des motifs de biopolymères sur des substrats solides par transfert laser. Ledit procédé consiste à utiliser des impulsions laser ultrarapides pour transférer du matériau biopolymère cible, dont les dimensions sont fonction du point focal du laser, d'une surface d'un support transparent sur la surface opposée du substrat de réception. La répétition du processus de transfert à différentes positions de cible et de substrat permet de produire des motifs élargis tels que des réseaux de caractéristiques ou des revêtements localisés. L'appareil est conçu pour produire de manière automatisée les motifs de biopolymères sur des substrats solides. Le procédé et l'appareil sont particulièrement utiles pour produire des dispositifs destinés à des systèmes de dosage biologique et biochimique tels que biocapteurs et jeux ordonnés de microéchantillons.

Ces trois derniers documents de l'art antérieur sont mal adaptées à une impression facile et maîtrisée, par exemple d'une encre biologique.

Aussi, la présente invention vise à remédier aux inconvénients de l'art antérieur en proposant un procédé d'impression qui permet d'imprimer avec une grande précision une large gamme d'éléments. En particulier, ce procédé permet d'imprimer une large gamme d'éléments biologiques, notamment de manière à obtenir des tissus biologiques complexes.

A cet effet, l'invention a pour objet un procédé d'impression d'au moins une encre conforme à la revendication 1 et optionnellement aux revendications dépendantes.

Cette configuration permet notamment d'obtenir une épaisseur E pour le film d'encre sensiblement constante, tout en limitant l'apparition des phénomènes de sédimentation. De plus, elle permet d'utiliser une large gamme d'encres.

L'encre imprimée par le procédé selon l'invention peut être n'importe quelle encre liquide et peut se présenter sous forme de solution ou sous forme de suspension. Parmi les encres utilisables, on peut citer notamment les encres biologiques, les encres utilisées en électronique ou en horlogerie.

Selon une application, l'encre est une encre biologique.

Selon une autre caractéristique, le film a une épaisseur inférieure à 500 µm et/ou a un ratio dimension de la surface libre du film sur épaisseur du film supérieur ou égal à 10.

De préférence, la distance séparant le film d'encre et la surface de dépose et/ou l'énergie du faisceau laser sont ajustées de sorte que l'énergie cinétique de la gouttelette soit quasi nulle lorsque la gouttelette touche la surface de dépose. Cette caractéristique limite les risques d'endommagement des éléments (cellules ou autres) contenus dans la gouttelette.

Selon une autre caractéristique, le procédé d'impression comprend une phase préalable de calibration de l'énergie du faisceau laser. Cette phase de calibration comprend une étape de mesure d'un angle de pointe d'une déformation de la surface libre du film d'encre à un instant fixe après l'impact du faisceau laser et une étape d'ajustement de l'énergie du faisceau laser en fonction de la valeur mesurée de l'angle de pointe.

De préférence, l'énergie du faisceau laser est ajustée de manière à ce que l'angle de pointe soit inférieur ou égal à 105°. Dans ce cas, l'énergie du faisceau laser est suffisante pour provoquer la formation d'une gouttelette.

Avantageusement, l'énergie du faisceau laser est ajustée de manière à ce que l'angle de pointe soit supérieur ou égal à un second seuil pour obtenir une énergie cinétique quasi nulle au moment où la gouttelette formée atteint la surface de dépose.

Pour un film d'encre, de préférence biologique, d'épaisseur de l'ordre de 40 et 50 µm, l'instant pour effectuer la mesure de l'angle de pointe est de préférence de l'ordre de 4 à 5 µs à compter de l'impact du faisceau laser.

Avantageusement, le film d'encre a une épaisseur supérieure à 20 µm.

Pour une encre qui est en suspension avec une forte concentration en éléments à imprimer, le film d'encre a de préférence une épaisseur comprise entre 40 et 60 µm.

Avantageusement, pour améliorer la précision du dépôt des éléments à imprimer, le film 74 d'encre a une épaisseur E comprise entre 1,5D et 2D, D étant le diamètre des éléments à imprimer qui ont une forme approximativement sphérique ou le diamètre d'une sphère dans laquelle au moins un élément à imprimer est inscrit.

L'invention a également pour objet un dispositif d'impression pour la mise en oeuvre du procédé d'impression de l'invention susvisé, conforme à la revendication 16.

D'autres caractéristiques et avantages ressortiront de la description qui va suivre de l'invention, description donnée à titre d'exemple uniquement, en regard des dessins annexés sur lesquels :
- La figure 1 est une représentation schématique d'un dispositif d'impression par laser qui illustre une variante de l'art antérieur,
- La figure 2 est une représentation schématique d'un dispositif d'impression par laser qui illustre une autre variante de l'invention,
- La figure 3 est une représentation schématique d'un dispositif d'impression par laser qui illustre l'invention,
- Les figures 4A à 4D sont des vues de côté illustrant la formation ou non d'une gouttelette en fonction de différents régimes,
- Les figures 5A à 5D sont des schémas qui illustrent une gouttelette à différents moments de sa formation, la dernière figure 5D illustrant l'instant où une gouttelette atteint un substrat receveur,
- La figure 6 est une coupe d'un support donneur illustrant le rapport entre la taille des éléments à imprimer et l'épaisseur d'un film d'encre biologique,
- Les figures 7A et 7B sont des vues de côté illustrant la formation d'une excroissance à la surface libre d'un film d'encre biologique, préalablement à la formation d'une gouttelette, au même instant mais produite avec des énergies différentes pour le faisceau laser,
- La figure 8 est une représentation schématique d'un dispositif d'impression selon un mode de réalisation de l'invention combinant au moins une tête d'impression de type laser et au moins une tête d'impression de type jet d'encre,
- La figure 9 est une vue en perspective d'un dispositif d'impression selon un mode de réalisation de l'invention combinant une tête d'impression de type laser et plusieurs têtes d'impression de type jet d'encre,
- La figure 10 est une vue en perspective d'une partie du dispositif d'impression de la figure 9 lors d'une impression avec une des têtes d'impression de type jet d'encre,
- La figure 11 est une coupe d'une partie du dispositif d'impression de la figure 9 lors d'une impression avec la tête d'impression de type laser,
- La figure 12 est une vue en perspectif d'une représentation en 3 dimensions d'une partie d'un tissu biologique que l'on cherche à reproduire,
- La figure 13 est une vue en perspective d'une tranche de la représentation de la figure 12,
- La figure 14 est une vue de dessus de la tranche de la figure 13 illustrant le positionnement des gouttelettes d'encres biologiques.

Sur la figure 3, on a représenté un dispositif d'impression 50 pour réaliser au moins un tissu biologique en assemblant couche par couche, selon un agencement prédéfini, différents constituants comme par exemple une matrice extracellulaire et différents morphogènes. Ainsi, le dispositif d'impression 50 permet de déposer couche par couche des gouttelettes 52 d'au moins une encre biologique 54 sur une surface de dépose 56 qui correspond à la surface d'un substrat receveur 58 pour la première couche ou à la dernière couche déposée sur ledit substrat receveur 58 pour les couches suivantes.

Dans un but de simplifier la représentation, la surface de dépose 56 correspond à la surface du substrat receveur 58 sur la figure 3.

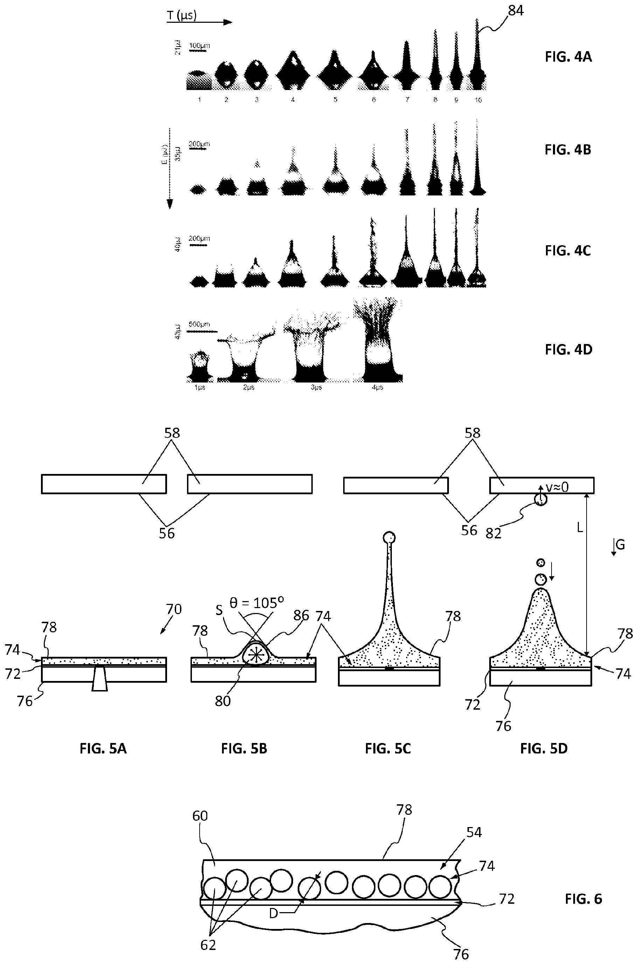

Selon un mode de réalisation sur la figure 6, l'encre biologique 54 comprend une matrice 60, par exemple un milieu aqueux, dans laquelle sont présents des éléments 62, par exemple des cellules ou des agrégats de cellules, à imprimer sur la surface de dépose 56.

Selon les cas, une encre biologique 54 comprend dans la matrice 60 une seule sorte d'éléments à imprimer 62 ou plusieurs sortes d'éléments à imprimer 62. En variante, l'encre biologique 54 peut ne comprendre qu'un seul constituant.

Par encre biologique, on entend pour la présente demande de brevet une matière biologique ou biomatériau. A titre d'exemple, l'encre biologique comprend seulement une matrice extracellulaire (par exemple du collagène), une matrice extracellulaire et des éléments tels que des cellules ou des agrégats de cellules, un milieu aqueux contenant des éléments tels que des cellules ou des agrégats de cellules.

L'encre biologique 54 n'est pas plus décrite car elle peut avoir différentes natures et des caractéristiques rhéologiques différentes d'une encre à l'autre.

Ce dispositif d'impression comprend une source laser 64 configurée pour émettre un faisceau laser 66 qui se caractérise entre autre par sa longueur d'onde, sa fréquence, son énergie, son diamètre, sa durée d'impulsion. De préférence, la source laser 64 est paramétrable afin d'ajuster au moins une caractéristique du faisceau laser, notamment son énergie.

Pour pouvoir former des gouttelettes dissociées les unes des autres, la source laser 64 est une source pulsée. Pour donner un ordre de grandeur, il est possible d'éjecter 10000 gouttelettes par seconde.

A titre d'exemple, la source laser 64 est une source laser avec une longueur d'onde de 1064 nm.

En plus, de la source laser, le dispositif d'impression 50 comprend un système optique 68 qui permet un réglage de la focalisation selon un axe Z perpendiculaire à la surface de dépose 56. Avantageusement, le système optique 68 comprend une lentille qui permet de focaliser le faisceau laser 66 sur une zone impactée. De préférence, le système optique 68 comprend un miroir pour modifier la position de la zone impactée. Ainsi, le système optique 68 permet de modifier la zone impactée par le faisceau laser dans un plan d'impact référencé Pi sur la figure 3.

La source laser 64 et le système optique 68 ne sont pas plus décrits car ils sont connus de l'homme du métier et peuvent être identiques à ceux de l'art antérieur.

Le dispositif d'impression 50 comprend également au moins un support donneur 70 qui comprend selon un mode de réalisation une couche absorbante 72 à la longueur d'onde du faisceau laser 66 sur laquelle est apposé un film 74 d'au moins une encre biologique.

Pour la suite de la description, on entend par film que l'encre biologique occupe un volume avec une épaisseur (dimension selon une direction perpendiculaire au plan d'impact Pi) inférieure à 500 µm.

Contrairement à un réservoir, le fait que l'encre biologique soit conditionnée sous la forme d'un film permet d'éviter les phénomènes de sédimentation.

La couche absorbante 72 est réalisée en un matériau adapté à la longueur d'onde du faisceau laser 66 pour transformer l'énergie lumineuse en un échauffement ponctuel de la couche absorbante 72.

De préférence, le support donneur 70 est positionné de manière à ce que le système optique focalise le faisceau laser au niveau de la couche absorbante 72.

Selon un mode de réalisation, la couche absorbante 72 est en or, en titane, ou autre en fonction de la longueur d'onde du faisceau laser 66.

Selon un autre mode de réalisation, le support donneur 70 ne comprend pas de couche absorbante 72. Dans ce cas, l'énergie du faisceau laser 66 est absorbée par l'encre.

De préférence, le support donneur 70 comprend une lame 76 en un matériau transparent à la longueur d'onde du faisceau laser 66 qui comprend sur une de ses faces un revêtement correspondant à la couche absorbante 72. La présence de la lame 76 confère une rigidité au support donneur 70 permettant de le manipuler et de conserver l'encre et/ou la couche absorbante 72 sensiblement plane dans le plan d'impact Pi.

Le film 74 d'encre biologique comprend une surface libre 78 qui est espacée de la couche absorbante 72 d'une distance E correspondant à l'épaisseur du film 74 et qui est espacée de la surface de dépose 56 d'une distance L. La surface libre 78 et la surface de dépose 56 se font face.

Comme illustré sur la figure 3, le faisceau laser 66 est adapté pour produire une cavité 80 à l'interface entre la couche absorbante et le film 74 d'encre biologique qui génère une gouttelette 82 qui se détache de la surface libre 78 pour se déplacer vers la surface de dépose 56.

Pour la suite de la description, une direction verticale est parallèle à la force gravitationnelle G et le sens haut-bas correspond au sens de la force gravitationnelle G.

La direction du faisceau laser 66 et la direction du mouvement de la gouttelette sont parallèles à la direction verticale.

### Tir vers le haut :

Selon une caractéristique de l'invention, le faisceau laser 66 et donc le mouvement de la gouttelette 82 sont orientés à contresens par rapport à la force gravitationnelle G. Ainsi, la surface libre 78 du film 74 d'encre biologique est orientée vers le haut. Lors de son mouvement du film 74 d'encre biologique vers la surface de dépose 56, la gouttelette 82 se déplace vers le haut, selon le sens bas-haut.

Cette configuration procure les avantages suivants :
- Elle limite l'apparition des phénomènes de sédimentation, l'encre biologique étant sous la forme d'un film,
- Elle permet d'obtenir une épaisseur E pour le film 74 d'encre biologique sensiblement constante, l'influence de la force gravitationnelle G sur la forme de la surface libre 78 du film 74 étant limitée du fait que la surface libre 78 est orientée vers le haut,
- Elle permet d'utiliser une large gamme d'encre biologique lorsqu'une couche absorbante 72 indépendante du film 74 d'encre biologique est utilisée pour transformer l'énergie lumineuse en un échauffement ponctuel.

### Energie cinétique quasi nulle au moment du dépôt d'une gouttelette sur le substrat receveur :

La formation d'une gouttelette 82 à partir d'un film d'encre biologique va dépendre de nombreux paramètres, essentiellement des caractéristiques de l'encre biologique, des caractéristiques du faisceau laser et des conditions de réalisation.

Sur les figures 4A à 4D, on a représenté l'évolution dans le temps de la déformation de la surface libre du film d'encre biologique, aboutissant ou non à la formation d'une gouttelette, pour différentes valeurs de l'énergie du faisceau laser 66, ce dernier ayant une énergie de 21 µJ pour la figure 4A, de 35 µJ pour la figure 4B, de 40 µJ pour la figure 4C et 43 µJ pour la figure 4D.

Pour la même encre biologique et dans les mêmes conditions de réalisation, on note qu'il existe plusieurs régimes en fonction de l'énergie du faisceau laser.

Comme illustré sur la figure 4A, si l'énergie du faisceau laser est inférieure à un seuil inférieur, la gouttelette ne se détache pas du film 74 d'encre biologique. La hauteur maximale de la déformation 84 générée au niveau de la surface libre 78 du film 74 de l'encre étant inférieure à la distance L séparant le film 74 et la surface de dépose 56, aucun élément n'est imprimé. Selon l'exemple choisi, le seuil inférieur est compris entre 21 µJ et 35 µJ. Comme illustré sur la figure 4D, si l'énergie du faisceau laser est supérieure à un seuil supérieur, la bulle de gaz 80 produite à l'intérieur du film éclate au niveau de la surface libre provoquant la projection incontrôlée de microgouttelettes. Selon l'exemple choisi, le seuil supérieur est compris entre 40 µJ et 43 µJ.

Entre les seuils inférieur et supérieur, comme illustré sur les figures 4B et 4C, on est en présence d'un régime permettant la formation d'un jet. Si la distance L séparant le film 74 et la surface de dépose 56 est suffisante, ce régime permet la formation d'une gouttelette.

De préférence, la distance L est de l'ordre de 1 à 2 mm pour permettre la formation d'une gouttelette et non d'un jet continu qui s'étire depuis le film jusqu'à la surface de dépose. Cette configuration limite les risques de contamination du tissu biologique réalisé par l'encre biologique.

Selon une autre caractéristique de l'invention, pour la même encre biologique et dans les mêmes conditions de réalisation, la distance L séparant le film 74 d'encre biologique et la surface de dépose 56 et/ou l'énergie du faisceau laser 66 sont ajustées de sorte que l'énergie cinétique de la gouttelette soit quasi nulle lorsque la gouttelette 82 touche la surface de dépose 56, comme illustré sur la figure 5D. Cette configuration limite le risque d'endommagement des éléments à imprimer qui sont des cellules.

Par quasi nulle, on entend que l'énergie cinétique est nulle ou très légèrement positive pour permettre à la gouttelette de se fixer sur la surface de dépose 56.

Cette circonstance est rendue possible du fait que la gouttelette 82 se déplace à contresens par rapport la force gravitationnelle G.

De préférence, la distance L séparant le film 74 d'encre biologique et la surface de dépose 56 est fixe. Par conséquent, l'énergie du faisceau laser 66 est ajustée de sorte à ce que l'énergie cinétique de la gouttelette soit quasi nulle lorsque la gouttelette 82 touche la surface de dépose 56.

Quelle que soit l'application, le fait d'imprimer avec un régime qui conduit à un dépôt à vitesse nulle permet de réduire les risques d'éclatement (splashing en anglais) de la gouttelette au moment du contact avec la surface de dépose.

### Technique de calibration :

Comme indiqué précédemment, la formation de la gouttelette n'est pas uniquement liée à l'énergie du faisceau laser. Elle est également liée à la nature de l'encre biologique notamment de sa viscosité, de sa tension de surface et aux conditions de réalisation.

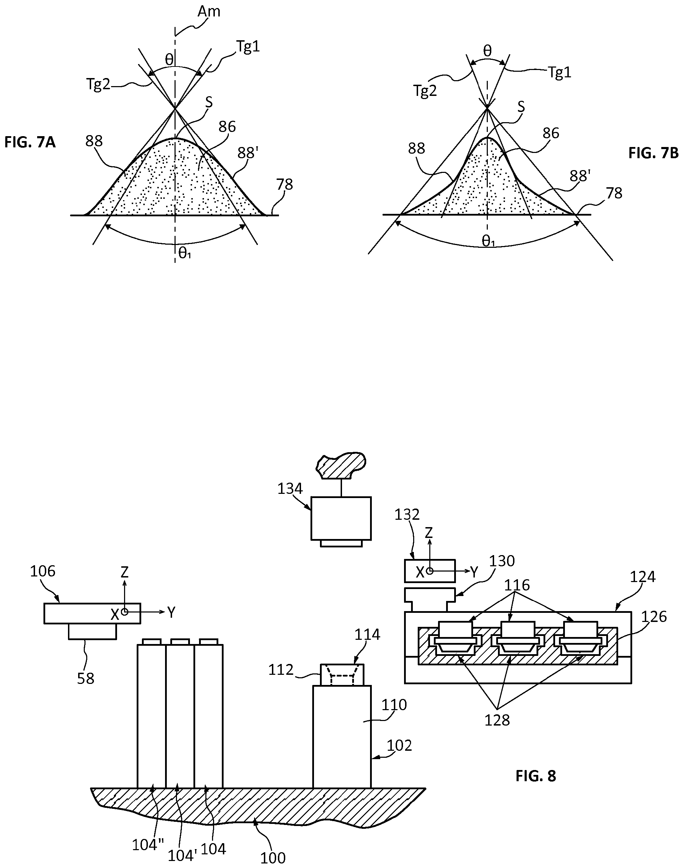

Sur les figures 5A à 5D, 7A à 7D, on a illustré un procédé de calibration permettant de déterminer l'énergie du faisceau laser pour obtenir un régime optimal concernant la formation et le dépôt des gouttelettes, notamment un régime qui conduit à un dépôt à vitesse nulle à une distance L donnée.

Sur les figures 5A à 5D, on a représenté certaines des étapes de formation d'une gouttelette 82 entre l'instant de l'impact du faisceau laser illustré sur la figure 5A et le dépôt de la gouttelette 82 sur la surface de dépose 56.

Selon une caractéristique de l'invention, le procédé de calibration permettant d'ajuster l'énergie du laser comprend les étapes consistant à mesurer un angle de pointe θ d'une déformation 86 de la surface libre 78 du film 74 de l'encre biologique à un instant T1 fixe après l'impact du faisceau laser 66 et à ajuster l'énergie du faisceau laser 66 en fonction de la valeur mesurée de l'angle de pointe θ.

Comme illustré sur les figures 5B, 7A et 7B, la déformation 86 a une forme symétrique par rapport à un axe médian Am parallèle à la direction verticale. Cette déformation 86 comprend un sommet S centré par rapport à l'axe médian Am. Ce sommet S correspond à la zone de la déformation 86 la plus éloignée du reste de la surface libre 78 du film 74.

Dans un plan contenant l'axe médian Am, le sommet S est prolongé par un premier flanc 88 d'un côté de l'axe médian Am et par un second flanc 88' de l'autre côté de l'axe médian Am, les deux flancs 88, 88' étant symétriques par rapport à l'axe médian Am.

Chaque flanc 88, 88' comprend un point d'inflexion.

Le premier flanc 88 comprend au niveau de son point d'inflexion une première tangente Tg1 et le second flanc 88' comprend au niveau de son point d'inflexion une seconde tangente Tg2, les deux tangentes Tg1 et Tg2 étant sécantes en un point de l'axe médian Am.

L'angle de pointe θ correspond à l'angle formé par les tangentes Tg1 et Tg2 et orienté vers le film 74 (soit vers le bas).

Pour obtenir la formation d'une gouttelette, l'angle de pointe θ doit être inférieur ou égal à un premier seuil θ1.

Ainsi, comme illustré sur la figure 7A, si l'angle de pointe θ est supérieur au premier seuil θ1, l'énergie du faisceau laser n'est pas suffisante pour générer une gouttelette. A contrario, comme illustré sur la figure 7B, si l'angle de pointe θ est inférieur au premier seuil θ1, l'énergie du faisceau laser est suffisante pour générer une gouttelette.

Pour obtenir une énergie cinétique quasi nulle au moment où la gouttelette formée atteint la surface de dépose 56 placée à une distance L de la surface libre 78 du film 74, l'angle de pointe θ doit être supérieur ou égal à un second seuil θ2.

De préférence, la valeur de l'angle de pointe θ est déterminée grâce à une prise de vue à l'instant T1 de la déformation 86. Selon un mode de réalisation, la prise de vue est réalisée grâce à une caméra dont l'axe de visée est perpendiculaire à la direction verticale.

L'instant T1 est fonction de l'épaisseur du film et varie très peu d'une encre à l'autre. Avantageusement, l'instant T1 est de l'ordre de 4 à 5 µs à compter de l'impact du faisceau laser pour une épaisseur E de film de l'ordre de 40 à 50 µm. Cet instant T1 correspond à la figure 5B.

Le premier seuil θ1 est approximativement égal à 105°. Ainsi, si à l'instant T1 l'angle de pointe θ est inférieur ou égal à 105°, l'énergie du faisceau laser est suffisante pour générer une gouttelette 82.

Le second seuil θ2 est fonction de la distance L entre la surface de dépose 56 et la surface libre 78 du film 74 de l'encre. Le second seuil θ2 est inversement proportionnel à la distance L.

Le second seuil θ2 est élevé et égal à approximativement 80° pour une distance L faible de l'ordre de 1 mm. Le choix d'une distance L relativement faible sera privilégié pour réduire les contraintes dans le jet et au moment du contact des gouttelettes avec la surface de dépose. Le second seuil θ2 est faible et égal à approximativement 50° pour une distance L importante de l'ordre de 10 mm. Le choix d'une distance L relativement importante sera privilégié si on souhaite imprimer à longue distance par exemple si le support donneur 70 a des dimensions plus importantes que celles du puits au fond duquel est positionnée la surface de dépose 56.

Cette technique de calibration de l'énergie du faisceau laser permet d'optimiser la vitesse du jet en la réduisant pour limiter les risques d'endommagement des éléments contenus dans l'encre notamment au moment du dépôt sur la surface de dépose 56.

### Epaisseur du film d'encre :

De préférence, l'encre biologique comprend une forte concentration en éléments à imprimer 62 afin d'obtenir un tissu biologique avec une forte concentration en cellules.

Dans ce cas, comme illustré sur la figure 3, la gouttelette 82 comprend une fraction volumique en éléments à imprimer 62 élevée.

Pour les encres biologiques à forte concentration, l'épaisseur E du film 74 est de l'ordre de 40 à 60 µm.

Avantageusement, pour améliorer la précision du dépôt des éléments à imprimer, le film 74 d'encre biologique a une épaisseur E comprise entre 1,5D et 2D, D étant le diamètre des éléments à imprimer 62 qui ont une forme approximativement sphérique ou le diamètre d'une sphère dans laquelle un élément à imprimer 62 est inscrit.

Selon un mode de réalisation, le film 74 d'encre biologique a une épaisseur E supérieure ou égale à 20 µm pour les plus petits éléments à imprimer qui ont un diamètre de l'ordre de 10 à 15 µm. L'épaisseur E du film peut être de l'ordre de 400 µm lorsque les éléments à imprimer 62 sont des agrégats de cellules.

Généralement, l'épaisseur E du film est inférieure à 100 µm lorsque les éléments à imprimer 62 sont des cellules unitaires.

De préférence, le film 74 se caractérise par un ratio (dimension de la surface libre 78)/(épaisseur du film 74) supérieur ou égal à 10, et avantageusement supérieur ou égal à 20. La dimension de la surface libre 78 correspond à la plus grande dimension de la surface libre 78 du film 74 prise dans un plan parallèle au plan d'impact Pi.

### Technique d'impression combinant une tête d'impression de type laser et une tête d'impression à buse :

Selon une autre caractéristique de l'invention, le procédé d'impression utilise au moins une tête d'impression de type laser pour au moins une première encre biologique et au moins une tête d'impression à buse pour au moins une deuxième encre biologique.

Cette combinaison permet d'augmenter le débit de fabrication.

Par tête d'impression à buse, on entend une tête d'impression qui comprend un orifice via lequel passe la deuxième encre biologique. Ainsi, une tête d'impression à buse peut être une tête d'impression de type jet d'encre, une tête d'impression par microvannes, une tête d'impression de type bioextrusion.

De préférence, chaque tête d'impression de type laser est identique à celle décrite sur la figure 3. Cependant, l'invention n'est pas limitée à cette tête d'impression de type laser.

Ainsi, il est envisageable d'utiliser les têtes d'impression de type laser décrites sur les figures 1 et 2 ou d'autres.

Les têtes d'impression à buse ne sont pas plus décrites car elles sont de préférence identiques à celles de l'art antérieur.

Dans le cas d'un tissu biologique comprenant des cellules disjointes séparées par des matériaux extracellulaires, les matériaux extracellulaires sont déposés de préférence par la ou les tête(s) d'impression à buse et les cellules sont déposées de préférence par la ou les tête(s) d'impression de type laser.

Les matériaux extracellulaires étant moins sensibles aux effets de cisaillement, il est possible de les déposer avec une tête d'impression à buse. Les cartouches d'encre biologique destinées aux têtes d'impression à buse ayant un volume très nettement supérieur au volume d'encre (de l'ordre de 40µl) supporté par un support donneur 70 destiné à une tête d'impression de type laser, il est possible de déposer les matériaux de la matrice extracellulaire avec un débit important. Même si une tête d'impression à buse est capable de déposer les encres avec un débit important, chaque support donneur destiné à une tête d'impression de type laser supportant un très faible volume d'encre, il est nécessaire de les changer fréquemment ce qui tend à augmenter le temps de dépose par rapport à une tête d'impression à buse.

Selon une autre caractéristique, la ou les tête(s) d'impression de type laser et la ou les tête(s) d'impression à buse sont intégrées dans une même machine et se déplacent dans le même référentiel. Cette configuration permet de simplifier le positionnement relatif des différentes têtes d'impression, d'améliorer la précision de dépose et de garantir l'intégrité des éléments imprimés.

### Dispositif d'impression comprenant une enceinte de stockage de supports donneurs :

Sur les figures 8 à 11, on a représenté un dispositif d'impression selon un mode de réalisation de l'invention.

Ce dispositif d'impression comprend un bâti 100 supportant une tête d'impression 102 de type laser et plusieurs têtes d'impression 104, 104', 104" de type jet d'encre. Ce bâti 100 comprend un repère X,Y,Z, l'axe Z étant orienté selon la direction verticale, le plan X,Y correspondant à un plan horizontal.

Les têtes d'impression 102, 104, 104', 104" sont fixes par rapport au bâti 100 et positionnées de manière à ce que les gouttelettes soient émises verticalement, vers le haut.

Les têtes d'impression 102, 104, 104', 104" sont décalées selon une première direction parallèle à l'axe Y. Selon un mode de réalisation, les têtes d'impression 104, 104', 104" de type jet d'encre sont accolées les unes contre les autres. La tête d'impression 102 de type laser est écartée des têtes d'impression 104, 104', 104" de type de jet.

Le dispositif d'impression comprend également un châssis mobile 106, un système de guidage et de déplacement du châssis mobile 106 par rapport au bâti 100 selon trois directions parallèles aux axes X,Y,Z et un système de commande permettant de contrôler les déplacements du châssis mobile 106. Le système de guidage et de déplacement et le système de contrôle sont choisis de manière à atteindre une précision micrométrique concernant les déplacements du châssis mobile 106 par rapport au bâti.

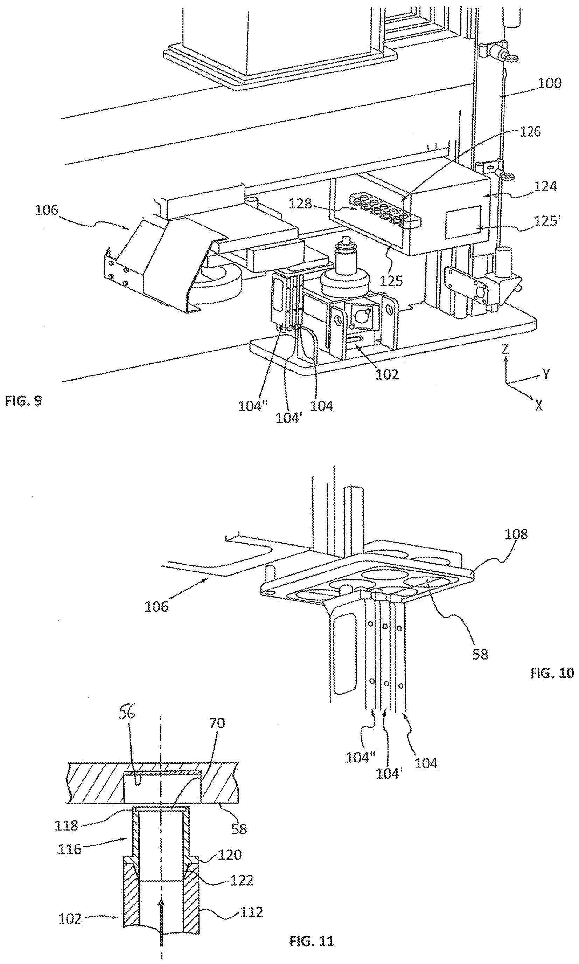

Comme illustré sur la figure 10, le châssis mobile 106 comprend un cadre 108 permettant de fixer de manière amovible au moins un substrat receveur 58. Lorsqu'il est solidarisé au châssis mobile, les déplacements du substrat receveur 58 sont contrôlés avec une précision micrométrique.

La tête d'impression 102 de type laser comprend un corps creux cylindrique 110, fixe par rapport au bâti, qui contient une partie d'un système optique et qui est surmonté d'une portion tubulaire 112 qui comprend une extrémité supérieure 114 placée qui débouche dans un plan horizontal. Ces éléments sont configurés de manière à ce qu'un faisceau laser guidé par le système optique balaie la section de l'extrémité supérieure 114.

Chaque support donneur 70 a la forme d'un disque positionné sur un socle 116.

Selon un mode de réalisation illustré sur la figure 11, chaque socle 116 a la forme d'un tube qui comprend au niveau de son bord supérieur un décrochement 118 qui a un diamètre identique à celui d'un support donneur 70 et une hauteur suffisante pour le maintenir. Ainsi, ce décrochement 118 permet de positionner un support donneur 70 par rapport au socle qui le reçoit.

L'extrémité supérieure 114 et le socle 116 ont des formes qui coopèrent entre elles de manière à ce que le socle 116 soit immobilisé selon une position donnée par rapport à l'extrémité supérieure 114 et donc par rapport au repère X,Y,Z du bâti. Selon un mode de réalisation, le socle 116 comprend une collerette 120 extérieure qui prend appui contre l'extrémité supérieure 114 et permet de positionner le socle selon l'axe Z. En dessous de la collerette 120, le socle 116 comprend une surface tronconique 122 qui coopère avec une portion tronconique prévue à l'intérieur de la portion tubulaire 112. Ces formes permettent de centrer le socle 116 par rapport à la portion tubulaire 112 et de le positionner dans un plan XY. De préférence, il est possible d'utiliser des matériaux magnétiques pour améliorer le positionnement du socle 116 par rapport à la portion tubulaire 112.

Avantageusement, le dispositif d'impression comprend une enceinte 124 configurée pour stocker au moins un socle 116. Cette enceinte 124 comprend au moins une ouverture 125 permettant de faire entrer et sortir le ou les socles 116 stockés. Selon un mode de réalisation, cette enceinte 124 a une forme parallélépipédique.

De préférence, l'enceinte 124 a des dimensions adaptées pour pouvoir stocker plusieurs socles. Ainsi, le dispositif d'impression peut imprimer successivement plusieurs encres biologiques avec la même tête d'impression 102 de type laser.

Les socles 116 sont stockés sur une embase 126 qui comprend des logements 128, un logement pour chaque socle 116. L'embase 126 a une forme allongée et comprend sur sa longueur des encoches 128 en U. Selon une première variante illustrée sur la figure 9, la longueur de l'embase 126 est orientée selon l'axe Y.

Selon une seconde variante privilégiée, la longueur de l'embase 126 est orientée selon l'axe X et les encoches 128 sont ouvertes en direction des têtes d'impression.

Avantageusement, l'enceinte 124 comprend sur une première face orientée vers les têtes d'impression une première ouverture 125 permettant de faire sortir les socles 116 et sur une autre face une deuxième ouverture 125' permettant d'introduire les socles 116.

Selon un mode de réalisation, l'enceinte 124 comprend un système de guidage pour positionner l'embase 126, par exemple un rail, l'embase 126 comprenant en partie inférieure une rainure dont la section coopère avec celle du rail. Ce rail débouche au niveau de la deuxième ouverture 125'. Il est de préférence orienté selon l'axe X.

L'enceinte 124 comprend des moyens de confinement pour conserver à l'intérieur de l'enceinte une atmosphère adaptée aux encres biologiques, notamment en température et/ou en hygrométrie. Ces moyens de confinement sont prévus notamment au niveau de chaque ouverture 125, 125'. Ils peuvent prendre la forme d'une barrière ou d'un rideau d'air.

En complément de l'enceinte, le dispositif d'impression comprend une pince mobile 130 pour déplacer les socles entre l'enceinte 124 et la tête d'impression 102 de type laser. Selon une première variante, la pince mobile 130 est solidarisée à un chariot mobile 132, indépendant du châssis mobile 106, qui est configuré pour se déplacer selon les directions X, Y, Z.

Selon une autre variante, la pince mobile 130 est solidarisée au châssis mobile 106.

Selon un mode de réalisation, le dispositif d'impression comprend un appareil de prise de vue (non représenté) dont l'axe de visée est perpendiculaire à la direction verticale et orientée au niveau de la surface supérieure du support donneur. Cet appareil peut être utilisé pour calibrer l'énergie du faisceau laser de la tête d'impression 102 de type laser.

### Procédé de réalisation d'un tissu biologique par bio-impression :

La première étape dudit procédé consiste à générer une représentation numérique en trois dimensions du tissu biologique à imprimer.

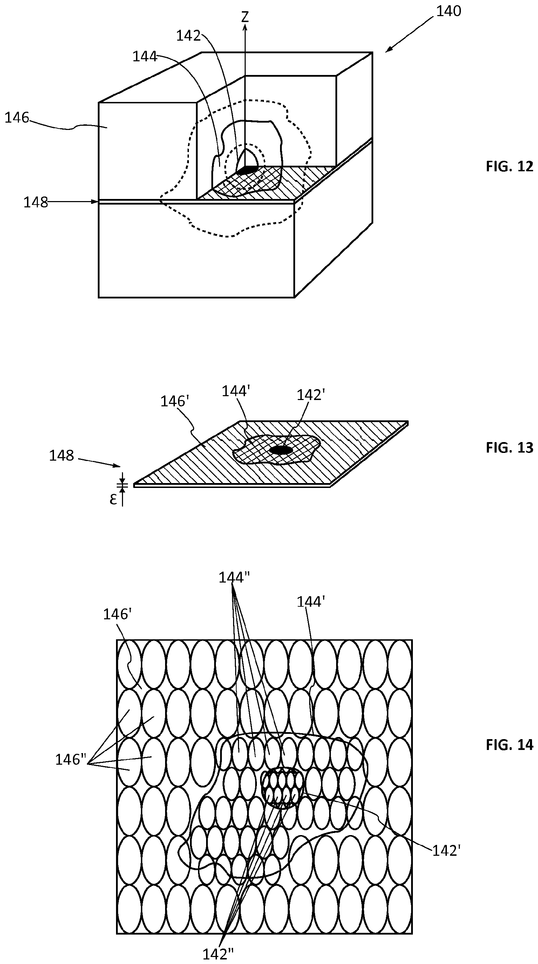

Sur la figure 12, on a représenté en 140 une partie d'une telle représentation sous la forme d'un cube qui comprend une première zone volumique 142 placée à l'intérieur d'une deuxième zone volumique 144 elle-même disposée dans une troisième zone volumique 146. Pour les besoins de la description, la représentation 140 est grandement simplifiée.

Chaque zone volumique 142, 144, 146 est colorée ou texturée différemment, chaque couleur ou texture correspondant à un ensemble de caractéristiques parmi les caractéristiques suivantes (non limitées) matériau, moyen de fabrication, trajectoire,...

De préférence, chaque couleur ou texture correspond à une encre biologique.

Toutes les zones volumiques 142, 144 et 146 sont fermées.

Avantageusement, la représentation comprend une pluralité de petits volumes élémentaires qui ont des couleurs ou textures différentes en fonction de la zone volumique à laquelle ils appartiennent. Selon un mode de réalisation, la représentation 140 est issue d'un fichier informatique de type PLY.

La deuxième étape du procédé consiste à trancher la représentation 140 en une succession de couches superposées selon un axe Z. Sur la figure 13, on a isolé une couche 148 de la représentation 140.

Lors du tranchage de la représentation 140, au droit d'un changement de zone volumique, chaque couche comprend une arête qui correspond à un changement de zone.

Comme illustré sur la figure 13, la couche 148 comprend une première zone 142' qui correspond à la première zone volumique 142, une deuxième zone 144' qui correspond à la deuxième zone volumique 144 et une troisième zone 146' qui correspond à la troisième zone volumique 146. Pour chaque couche, les zones 142', 144', 146' sont colorées ou texturées en fonction de la couleur ou texture des zones volumiques 142, 144, 146.

Chaque couche a une épaisseur ε qui est déterminée en fonction de la hauteur des gouttelettes imprimées.

Si la couche ne comprend qu'une seule matière à imprimer, la couche a une épaisseur sensiblement égale à la hauteur d'une gouttelette.

Lorsque la couche comprend plusieurs matières à imprimer, selon une première variante, la couche a une épaisseur égale au plus petit commun multiple des hauteurs des gouttelettes associées à chaque matière. Cette variante a pour avantage de minimiser le décalage dans toute la hauteur de l'objet à imprimer et d'aboutir à une impression rapide.

Selon une deuxième variante, la couche a une épaisseur égale au plus grand commun diviseur des hauteurs des gouttelettes associées à chaque matière. Cette variante a pour avantage d'augmenter la résolution et le nombre de couches.

A titre d'exemple, si la première matière est imprimée par bio-impression par laser, les gouttelettes imprimées ont une hauteur de l'ordre de 10 µm. Si la deuxième matière est imprimée par bio-impression par microvannes, les gouttelettes imprimées ont une hauteur de l'ordre de 100 µm. Selon la première variante, les couches ont une épaisseur de l'ordre de 100 µm. Selon la deuxième variante, les couches ont une épaisseur de l'ordre de 10 µm. De préférence, chaque couche comprend une pluralité de petits polygones élémentaires par exemple triangulaire qui ont des couleurs différentes en fonction de la zone à laquelle ils appartiennent.

Ainsi, l'objet à imprimer correspond à un ensemble de couches qui comprennent chacune un ensemble de polygones qui ont chacun une couleur ou une texture associée.

Une troisième étape du procédé consiste à déterminer pour chaque couche la position des gouttelettes à imprimer de chaque encre biologique en fonction des zones 142', 144', 146' colorées ou texturées et du volume prévu de chacune des gouttelettes. A cet effet, chaque zone 142', 144', 146' de chaque couche est remplie par des ellipses 142", 144", 146" dont les dimensions sont fonction des dimensions des gouttelettes de l'encre biologique destinée à être imprimée dans ladite zone, comme illustré sur la figure 14.

Pour chaque zone, les ellipses ont les mêmes dimensions. Toutes les ellipses ont des axes focaux parallèles.

La forme elliptique permet de pouvoir adapter les distances entre les gouttelettes selon deux directions (une première direction parallèle aux axes focaux et une seconde direction perpendiculaire à la première).

Le centre de chaque ellipse correspond à la position du centre d'une gouttelette.

Le positionnement des ellipses se fait zone par zone, par ordre décroissant de grosseurs, Ainsi, les plus grosses ellipses disposées dans la zone 146' sont positionnées en premier et les plus petites ellipses disposées dans la zone 142' sont positionnées en dernier.

De préférence, au niveau d'un changement de zone, l'optimisation du positionnement se fait selon deux critères :
- ratio maximal de polygones élémentaires ayant la bonne couleur ou texture au sein d'une ellipse, de l'ordre de 75% par exemple,
- Ratio minimal de polygones élémentaires ayant la mauvaise couleur ou texture au sein d'une ellipse, de l'ordre de 5% par exemple.

Les chevauchements entre ellipses peuvent être tolérés.

Une quatrième étape du procédé consiste à synchroniser le déplacement de la surface de dépose 56 sur laquelle les gouttelettes d'encre biologique sont imprimées et les différentes têtes d'impression.

Pour une bio-impression par laser, la zone de focalisation du laser est le centre de chaque ellipse imprimée par laser, et chaque ellipse fait l'objet d'un pulse laser. Dans ce cas, la surface de dépose est fixe, c'est le laser qui balaie toute la surface de dépose. Pour une surface de dépose plus grande que le support donneur, Il est possible de déplacer également le substrat (sur lequel sont rapportées les surfaces de dépose) de manière synchronisée avec le balayage du laser.

Pour une bio-impression à buse, le centre de chaque ellipse correspond au point d'impact supposé d'une gouttelette sur la surface de dépose 56. Dans ce cas, la buse d'impression est fixe, c'est le substrat qui se déplace. Toutefois, la buse d'impression pourrait être mobile.

### Applications :

La bio-impression selon l'invention peut être utilisée pour produire :
- Des tissus implantables pour la médecine régénératrice,
- Des tissus individualisés, réalisés à partir des cellules du patient, permettant de sélectionner *in vitro* les traitements et de développer des solutions thérapeutiques personnalisées,
- Des modèles prédictifs reproduisant la physiologie de tissus humains sains ou de tissus affectés par une pathologie pour tester de manière prédictive l'efficacité ou la toxicité des molécules, d'ingrédients et des candidats médicaments.

A titre d'exemple et de manière non limitative, le tissu biologique est un tissu osseux.

Bien que décrite appliquée aux encres biologiques, l'invention n'est pas limitée à cette application. Ainsi, le procédé et le dispositif selon l'invention peuvent être utilisés pour imprimer n'importe quelle encre liquide, sous forme de solution ou de suspension. Parmi les autres encres utilisables, on peut citer de manière non limitative les encres utilisées dans les revêtements en électronique, dans les matériaux ou en horlogerie.

A titre d'exemple et de manière non limitative, les encres peuvent être composées :
- De Métaux précieux (notamment d'or, d'argent, de platine, de rhodium et de palladium) ou semi-précieux (de titane, de zirconium, de cuivre),
- D'alliages fonctionnels,
- De matériaux organiques,
- De systèmes sol-gel,
- De céramiques ou microcomposites ou nanocomposites.

Ces différents matériaux permettent de réaliser différents types de revêtements :
- Anticorrosions,
- Avec une haute résistance chimique,
- Biofonctionnels (antibactérien, antimicrobien, biocompatible),
- Pour le contact alimentaire,
- Modifiant l'énergie de surface,
- Antiadhésifs,
- Electrotechniques (isolants, antistatiques ou conducteurs),
- Anti-usures,
- Modifiant les propriétés optiques (antireflet, photo-catalytique, barrière IR/UV),
- Modifiant le sens haptiques,
- Permettant de réduire le coefficient de friction,
- Permettant d'augmenter la durabilité à haute température,..

## Revendications

1. Procédé d'impression d'au moins une encre, ledit procédé comprenant une étape de focalisation d'un faisceau laser (66) de manière à générer une cavité dans un film (74) d'encre, une étape de formation d'au moins une gouttelette (82) d'encre à partir d'une surface libre (78) du film (74) d'encre et une étape de dépôt de ladite gouttelette (82) sur une surface de dépose (56) d'un substrat receveur (58) positionnée à une distance donnée (L) du film (74), le faisceau laser (66) étant orienté à contresens par rapport à la force gravitationnelle (G), la surface libre (78) du film étant orientée vers le haut en direction de la surface de dépose (56) placée au-dessus du film (74) d'encre **caractérisé en ce que** la distance (L) séparant le film (74) d'encre et la surface de dépose (56) et/ou l'énergie du faisceau laser (66) sont ajustées de sorte que l'énergie cinétique de la gouttelette soit quasi nulle lorsque la gouttelette (82) touche la surface de dépose (56).

2. Procédé d'impression selon la revendication 1, **caractérisé en ce que** le film (74) a une épaisseur inférieure à 500 µ 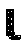 η.

3. Procédé d'impression selon la revendication 1 ou 2, **caractérisé en ce que** le film a un ratio dimension de la surface libre du film (74) sur épaisseur du film (74) supérieur ou égal à 10.

4. Procédé d'impression selon la revendication 1, **caractérisé en ce que** la distance (L) séparant le film (74) d'encre et la surface de dépose (56) est de 1 à 2 mm et **en ce que** l'énergie du faisceau laser (66) est ajustée de sorte que l'énergie cinétique de la gouttelette soit quasi nulle lorsque la gouttelette (82) touche la surface de dépose (56).

5. Procédé d'impression selon l'une quelconque des revendications précédentes, **caractérisé en ce que** le procédé d'impression comprend une phase préalable de calibration de l'énergie du faisceau laser qui comprend une étape de mesure d'un angle de pointe (Θ) d'une déformation (86) de la surface libre (78) du film (74) d'encre à un instant (Tl) fixe après l'impact du faisceau laser (66) et une étape d'ajustement de l'énergie du faisceau laser (66) en fonction de la valeur mesurée de l'angle de pointe (Θ).

6. Procédé d'impression selon la revendication 5, **caractérisé en ce que** l'énergie du faisceau laser est ajustée de manière à ce que l'angle de pointe (Θ) soit inférieur ou égal à 105°.

7. Procédé d'impression selon la revendication 5 ou 6, **caractérisé en ce que** l'énergie du faisceau laser est ajustée de manière à ce que l'angle de pointe (Θ) soit supérieur ou égal à un second seuil pour obtenir une énergie cinétique quasi nulle au moment où la gouttelette formée atteint la surface de dépose (56).

8. Procédé d'impression selon la revendication précédente, **caractérisé en ce que** le second seuil est fonction de la distance (L) entre la surface de dépose (56) et la surface libre (78) du film (74) de l'encre.

9. Procédé d'impression selon la revendication précédente, **caractérisé en ce que** le second seuil est égal à approximativement 80° pour une distance (L) de l'ordre de 1 mm.

10. Procédé d'impression selon l'une des revendications 5 à 9, **caractérisé en ce que** l'instant (Tl) de mesure de l'angle de pointe (Θ) est de l'ordre de 4 à 5 µ≤ à compter de l'impact du faisceau laser (66).

11. Procédé d'impression selon l'une des revendications précédentes, **caractérisé en ce que** le film d'encre a une épaisseur supérieure à 20 µ 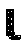 η.

12. Procédé d'impression selon l'une des revendications précédentes, **caractérisé en ce que** le film d'encre a une épaisseur comprise entre 40 et 60 µ 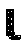 η pour les encres biologiques avec une forte concentration en éléments à imprimer (62).

13. Procédé d'impression selon l'une des revendications 1 à 11, **caractérisé en ce que** pour une encre biologique avec une faible concentration en éléments à imprimer (62), le film (74) d'encre biologique a une épaisseur comprise entre 1,5D et 2D, D étant le diamètre des éléments à imprimer (62) qui ont une forme approximativement sphérique ou le diamètre d'une sphère dans laquelle un élément à imprimer (62) est inscrit.

14. Dispositif d'impression pour la mise en oeuvre du procédé d'impression selon l'une des revendications précédentes, ledit dispositif d'impression comprenant :
- au moins une source laser (64) puisée, configurée pour émettre un faisceau laser (66),
- un système optique (68) pour focaliser et orienter ledit faisceau laser (66),
- au moins un support donneur (70) sur lequel est apposé un film (74) d'au moins une encre avec une surface libre (78), et
- au moins un substrat receveur (58) comprenant une surface de dépose (56) positionnée à une distance donnée (L) du film (74), **caractérisé en ce que** le faisceau laser (66) est orienté à contresens par rapport à la force gravitationnelle (G) et **en ce que** la surface libre (78) du film est orientée vers le haut en direction de la surface de dépose (56) placée au-dessus du film d'encre,
- la distance (L) séparant le film (74) d'encre et la surface de dépose (56) et/ou l'énergie du faisceau laser (66) étant ajustées de sorte que l'énergie cinétique de la gouttelette soit quasi nulle lorsque la gouttelette (82) touche la surface de dépose (56).

## Patentansprüche

1. Druckverfahren für zumindest eine Druckfarbe, wobei besagtes Verfahren einen Schritt der Fokussierung eines Laserstrahls (66) umfasst, in dem ein Hohlraum in einem Farbfilm (74) gebildet wird, einen Schritt der Formung von zumindest einem Tropfen (82) Druckfarbe ausgehend von einer freien Oberfläche (78) des Farbfilms (74), und ein Schritt des Auftragens besagten Tropfens (82) auf einer Auftragsfläche (56) eines Empfängersubstrats (58), das in einer bestimmten Entfernung (L) zum Film (74) positioniert ist, wobei der Laserstrahl (66) gegenläufig zur Gravitationskraft (G) ausgerichtet ist, wobei die freie Oberfläche (78) des Filmes nach oben in Richtung der oberhalb des Farbfilms (74) platzierten Auftragsfläche (56) ausgerichtet ist, **dadurch gekennzeichnet, dass** die Entfernung (L), welche den Film (74) und die Auftragsfläche (56) und/oder die Energie des Laserstrahls (66) voneinander trennt, so angepasst ist, dass die kinetische Energie des Tropfens annähernd Null ist, wenn der Tropfen (82) die Auftragsfläche (56) berührt.

2. Druckverfahren nach Anspruch 1, **dadurch gekennzeichnet, dass** der Film (74) eine Dicke kleiner 500 µm hat.

3. Druckverfahren nach Anspruch 1 oder 2, **dadurch gekennzeichnet, dass** das Größenverhältnis der freien Oberfläche des Films (74) zur Dicke des Films (74) größer/gleich 10 ist.

4. Druckverfahren nach Anspruch 1, **dadurch gekennzeichnet, dass** die Entfernung (L), welche den Farbfilm (74) und die Auftragsfläche (56) voneinander trennt, 1 bis 2 mm beträgt, und dadurch, dass die Energie des Laserstrahls (66) so angepasst ist, dass die kinetische Energie des Tropfens annähernd Null ist, wenn der Tropfen (82) die Auftragsfläche (56) berührt.

5. Druckverfahren nach einem der vorhergehenden Ansprüche, **dadurch gekennzeichnet, dass** das Druckverfahren eine Vorabphase der Kalibrierung der Energie des Laserstrahls umfasst, die einen Schritt der Messung eines Spitzenwinkels (Θ) einer Verformung (86) der freien Fläche (78) des Farbfilms (74) zu einem feststehenden Zeitpunkt (TI) nach Auftreffen des Laserstrahls (66) umfasst, und einen Schritt der Anpassung der Energie des Laserstrahls (66) an den gemessenen Wert des Spitzenwinkels (Θ).

6. Verfahren nach Anspruch 5, **dadurch gekennzeichnet, dass** die Energie des Laserstrahls so angepasst wird, dass der Spitzenwinkel (Θ) kleiner/gleich 105° ist.

7. Druckverfahren nach Anspruch 5 oder 6, **dadurch gekennzeichnet, dass** die Energie des Laserstrahls so angepasst ist, dass der Spitzenwinkel (Θ) größer/gleich einem zweiten Grenzwert ist, um zum Zeitpunkt, an dem der gebildete Tropfen die Auftragsfläche (56) erreicht, eine kinetische Energie von annähernd Null zu erzielen.

8. Druckverfahren nach dem vorhergehenden Anspruch, **dadurch gekennzeichnet, dass** der zweite Grenzwert abhängig ist von der Entfernung (L) zwischen der Auftragsfläche (56) und der freien Oberfläche (78) des Farbfilms (74).

9. Druckverfahren nach dem vorhergehenden Anspruch, **dadurch gekennzeichnet, dass** der zweite Grenzwert bei einer Entfernung (L) von 1 mm ungefähr 80° beträgt.

10. Druckverfahren nach einem der Ansprüche 5 bis 9, **dadurch gekennzeichnet, dass** der Zeitpunkt (TI) der Messung des Spitzenwinkels (Θ) bei 4 bis 5 µm ab dem Auftreffen des Laserstrahls (66) liegt.

11. Druckverfahren nach einem der vorhergehenden Ansprüche, **dadurch gekennzeichnet, dass** der Farbfilm eine Dicke größer 20 µm hat.

12. Druckverfahren nach einem der vorhergehenden Ansprüche, **dadurch gekennzeichnet, dass** der Farbfilm bei biologischer Farbe mit einer starken Konzentration an Druckelementen (62) eine Dicke zwischen 40 und 50 µm hat.

13. Druckverfahren nach einem der Ansprüche 1 bis 11, **dadurch gekennzeichnet, dass** bei einer biologischen Druckfarbe mit einer geringen Konzentration an Druckelementen (62) der biologische Farbfilm (74) eine Dicke von 1,5D und 2D hat, wobei D der Durchmesser der Druckelemente (62) ist, die annähernd kugelförmig sind, oder der Durchmesser einer Kugel, in welcher ein Druckelement (62) enthalten ist.

14. Druckvorrichtung zur Anwendung des Druckverfahrens nach einem der vorhergehenden Ansprüche, wobei besagte Druckvorrichtung folgendes umfasst:
- mindestens eine gepulste Laserquelle (64), dergestalt, dass sie einen Laserstrahl (66) emittiert,
- ein optisches System (68), um besagten Laserstrahl (66) zu fokussieren und auszurichten,
- zumindest eine Geberhalterung (70), auf der ein Film (74) aus zumindest einer Farbe mit einer freien Oberfläche (78) aufgebracht ist, und
- zumindest ein Empfängersubstrat (58), welches einen Auftragsfläche (56) umfasst, die in einer bestimmten Entfernung (L) zum Film (74) positioniert ist, **dadurch gekennzeichnet, dass** der Laserstrahl (66) gegenläufig zur Gravitationskraft (G) ausgerichtet ist, und dadurch, dass die freie Oberfläche (8) des Films nach oben in Richtung der oberhalb des Farbfilms platzierten Auftragsfläche (56) ausgerichtet ist,
- wobei die Entfernung (L), die den Farbfilm (74) und die Auftragsfläche (56) und/oder die Energie des Laserstrahls (66) voneinander trennt, so angepasst ist, dass die kinetische Energie des Tropfens annähernd Null ist, wenn der Tropfen (82) die Auftragsfläche (56) berührt.

## Claims

1. A method for printing with at least one ink, said method comprising a step of focusing a laser beam (66) so as to generate a cavity in an ink film (74), a step of forming at least one ink droplet (82) from a free surface (78) of the ink film (74) and a step of depositing said droplet (82) onto a depositing surface (56) of a receiver substrate (58) positioned at a given distance (L) from the film (74), with the laser beam (66) being oriented in the direction opposite the gravitational force (G), the free surface (78) of the film being oriented upwards towards the depositing surface (56) placed above the ink film (74), **characterized in that** the distance (L) separating the ink film (74) and the depositing surface (56) and/or the energy of the laser beam (66) are so adjusted that the kinetic energy of the droplet is almost null when the droplet (82) contacts the depositing surface (56).

2. A printing method according to claim 1, **characterized in that** the film (74) has a thickness of less than 500µm.

3. A printing method according to claim 1 or 2, **characterized in that** the film has a dimension of the free surface of the film (74) to the thickness of the film (74) ratio greater than or equal to 10.

4. A printing method according to claim 1, **characterized in that** the distance (L) separating the ink film (74) and the depositing surface (56) is 1 or 2mm, and **in that** the energy of the laser beam (66) is so adjusted that the kinetic energy of the droplet is almost null when the droplet (82) contacts the depositing surface (56).

5. A printing method according to any one of the preceding claims, **characterized in that** the printing method comprises a preliminary phase of calibration of the energy of the laser beam which comprises a step of measuring a tip angle (Θ) of a deformation (86) of the free surface (78) of the ink film (74) at a time (Tl) fixed after the impact of the laser beam (66) and a step of adjusting the energy of the laser beam (66) according to the measured value of the tip angle (Θ).

6. A printing method according to claim 5, **characterized in that** the energy of the laser beam is so adjusted that the tip angle (Θ) is less than or equal to 105°.

7. A printing method according to claim 5 or 6, **characterized in that** the energy of the laser beam is so adjusted that the tip angle (Θ) is greater than or equal to a second threshold to obtain an almost null kinetic energy when the formed droplet contacts the depositing surface (56).

8. A printing method according to the preceding claim, **characterized in that** the second threshold depends on the distance (L) between the depositing surface (56) and the free surface (78) of the ink film (74).

9. A printing method according to the preceding claim, **characterized in that** the second threshold is equal to approximately 80° for a distance (L) of the order of 1mm.

10. A printing method according to one of claims 5 to 9, **characterized in that** the time (T) for measuring the tip angle (Θ) is of the order of 4 to 5µm from the impact of the laser beam (66).

11. A printing method according to one of the preceding claims, **characterized in that** the ink film has a thickness greater than 20µm.

12. A printing method according to one of the preceding claims, **characterized in that** the ink film has a thickness between 40 and 60µm for biological inks with a high concentration of elements to be printed (62).

13. A printing method according to one of claims 1 to 11, **characterized in that**, for a biological ink with a low concentration of elements to be printed (62), the film (74) of biological ink has a thickness ranging from 1.5D to 2D, with D being the diameter of the elements to be printed (62) which have a substantially spherical shape or the diameter of a sphere in which an item to be printed (62) is inscribed.

14. A printing device for implementing the printing method according to one of the preceding claims, said printing device comprising:
- at least one pulsed laser source (64), so configured as to emit a laser beam (66),
- an optical system (68) for focusing and directing said laser beam (66),
- at least one donor support (70) whereon a film (74) of at least one ink with a free surface (78) is affixed, and
- at least one receiver substrate (58) comprising a depositing surface (56) positioned at a given distance (L) from the film (74), **characterized in that** the laser beam (66) is oriented in the direction opposite the gravitational force (G), and **in that** the free surface (78) of the film is oriented upwards towards the depositing surface (56) placed above the ink film (74),
- the distance (L) separating the ink film (74) and the depositing surface (56) and/or the energy of the laser beam (66) being so adjusted that the kinetic energy of the droplet is almost null when the droplet (82) contacts the depositing surface (56).
